# EUROPEAN PATENT APPLICATION

(11) **EP 4 311 108 A1**
(43) Date of publication of application: **24.01.2024**
(21) Application number: 22771282.5
(22) Date of filing: 10.03.2022
(51) Int. Cl.: H03H 3/02, H03H 9/19

(54) **QUARTZ RESONATOR AND METHOD FOR PRODUCING SAME**

(30) Priority: 17.03.2021 JP 2021043931
(71) Applicant: Daishinku Corporation, Kakogawa-shi, Hyogo 675-0194 (JP)
(72) Inventor: MORIMOTO, Yoshinari, Kakogawa-shi, Hyogo 675-0194 (JP)
(74) Representative: Hoffmann Eitle
(86) International application number: PCT/JP2022/010698
(87) International publication number: WO 2022/196532

(57) **Abstract**

In a crystal resonator (100), a crystal resonator plate (10) includes: a vibrating part (11); an external frame part (12) provided at a side of an outer periphery of the vibrating part (11); and a penetrating part (10a) provided between the vibrating part (11) and the external frame part (12) so as to penetrate the crystal resonator plate (10) in a thickness direction of the crystal resonator plate (10). An inclined surface (11c) is provided at an end part of the vibrating part (11) at the side of the penetrating part (10a) so as to protrude in the thickness direction and to be inclined with respect to a vibrating surface (11b) of the vibrating part (11).

## Description

### Technical Field

The present invention relates to a crystal resonator including an SC-cut crystal resonator plate and a method for manufacturing the crystal resonator.

### Background Art

Conventionally, a crystal resonator including an SC-cut crystal resonator plate (hereinafter also referred to as the "SC-cut crystal resonator") is known as a crystal resonator used for an oven-controlled crystal oscillator (for example, see Patent Documents 1 and 2). The SC-cut crystal resonator has temperature characteristics expressed by a cubic curve similarly to those of the crystal resonator including an AT-cut crystal resonator plate, and this cubic curve has an inflection point at approximately 94°C where the temperature gently changes.

### Prior Art Documents

### Patent Documents

[Patent Document 1] JP 3 194442
[Patent Document 2] WO 2005/008887

### Summary of the Invention

### Problem to Be Solved by the Invention

The above-described SC-cut crystal resonator generates B-mode vibration apart from C-mode vibration as the main vibration (fundamental wave). In the case of a rectangle-shaped SC-cut crystal resonator plate, the oscillation frequency in B mode is about 1.09 times the oscillation frequency in C mode. Also, the equivalent resistance (hereinafter referred to as "CI") in B mode is approximately equal to or occasionally smaller than the CI in C mode. Therefore, if no special measures are taken, the SC-cut crystal resonator may oscillate in B mode, which results in low reliability.

The present invention was made in consideration of the above circumstances, an object of which is to provide a highly-reliable crystal resonator capable of oscillating certainly in C mode as the main vibration, and also to provide a method for manufacturing the above crystal resonator.

### Means for Solving the Problem

In order to solve the above problem, the present invention provides a crystal resonator including an SC-cut crystal resonator plate. The SC-cut crystal resonator plate includes: a vibrating part; an external frame part provided at a side of an outer periphery of the vibrating part; and a penetrating part provided between the vibrating part and the external frame part so as to penetrate the SC-cut crystal resonator plate in a thickness direction of the SC-cut crystal resonator plate. An inclined surface is provided at an end part of the vibrating part at a side of the penetrating part so as to protrude in the thickness direction and to be inclined with respect to a vibrating surface of the vibrating part.

With the above-described configuration, the oscillation of the crystal resonator in B mode is reduced by the inclined surface. As a result, it is possible to certainly make the crystal resonator oscillate in C mode as the main vibration, and thus, it is possible to provide a highly reliable crystal resonator.

In the above-described configuration, it is preferable that a second inclined surface is formed on a part opposite to the inclined surface so as to be inclined in the direction in which the inclined surface protrudes. With this configuration, the oscillation of the crystal resonator in B mode is effectively reduced by both the inclined surface and the second inclined surface. As a result, it is possible to certainly make the crystal resonator oscillate in C mode as the main vibration, and thus, it is possible to provide a highly reliable crystal resonator.

In the above-described configuration, it is preferable that the width of the inclined surface in a first direction along a crystal axis (for example, a Z axis) of the SC-cut crystal resonator plate accounts for 10% or more of the width of the vibrating part in the first direction. With this configuration, the oscillation of the crystal resonator in B mode is reduced by the inclined surface having a certain width. As a result, it is possible to certainly make the crystal resonator oscillate in C mode as the main vibration, and thus, it is possible to provide a highly reliable crystal resonator.

In the above-described configuration, it is preferable that the inclined surface is provided at the end part of the vibrating part in the Z axis direction of the SC-cut crystal resonator plate so as to extend in the X axis direction of the SC-cut crystal resonator plate. With this configuration, the oscillation of the crystal resonator in B mode is reduced by the inclined surface having a certain width in the Z axis direction of the SC-cut crystal resonator plate. As a result, it is possible to certainly make the crystal resonator oscillate in C mode as the main vibration, and thus, it is possible to provide a highly reliable crystal resonator.

Also, the present invention provides a method for manufacturing a crystal resonator including an SC-cut crystal resonator plate. The method includes the steps of: performing a frequency adjustment etching to one surface side of the SC-cut crystal resonator plate; and performing an outline etching, after the frequency adjustment etching, to form a penetrating part at an end part of a vibrating part, so that an inclined surface is formed at the end part of the vibrating part at a side of the penetrating part so as to protrude in a thickness direction and to be inclined with respect to a vibrating surface of the vibrating part.

With the above-described configuration, by subjecting one surface side of the crystal resonator plate to the frequency adjustment etching, the inclined surface that is inclined with respect to the vibrating surface of the vibrating part appears due to crystal anisotropy. The smaller the size of the crystal resonator becomes, the smaller the width of the penetrating part becomes, which leads to a smaller amount of etching by the outline etching to form the penetrating part. As a result, after the outline etching is performed, the inclined surface formed by the frequency adjustment etching remains at the end part of the vibrating part. Thus, the oscillation of the crystal resonator in B mode is reduced by the inclined surface. As a result, it is possible to certainly make the crystal resonator oscillate in C mode as the main vibration, and thus, it is possible to provide a highly reliable crystal resonator.

In the above-described configuration, it is preferable that the width of the inclined surface in a first direction along a crystal axis (for example, a Z axis) of the SC-cut crystal resonator plate accounts for 10% or more of the width of the vibrating part in the first direction. With this configuration, the oscillation of the crystal resonator in B mode is reduced by the inclined surface formed at the end part of the vibrating part after the outline etching. As a result, it is possible to certainly make the crystal resonator oscillate in C mode as the main vibration, and thus, it is possible to provide a highly reliable crystal resonator.

In the above-described configuration, it is preferable that the inclined surface is provided at the end part of the vibrating part in the Z axis direction of the SC-cut crystal resonator plate so as to extend in the X axis direction of the SC-cut crystal resonator plate. With this configuration, the oscillation of the crystal resonator in B mode is reduced by the inclined surface formed at the end part of the vibrating part in the Z axis direction after the outline etching. As a result, it is possible to certainly make the crystal resonator oscillate in C mode as the main vibration, and thus, it is possible to provide a highly reliable crystal resonator.

### Effects of the Invention

With the present invention, the oscillation of the crystal resonator in B mode can be reduced by an inclined surface. Therefore, it is possible to certainly make the crystal resonator oscillate in C mode as the main vibration, and thus, it is possible to provide a highly reliable crystal resonator.

### Brief Description of the Drawings

[FIG. 1]

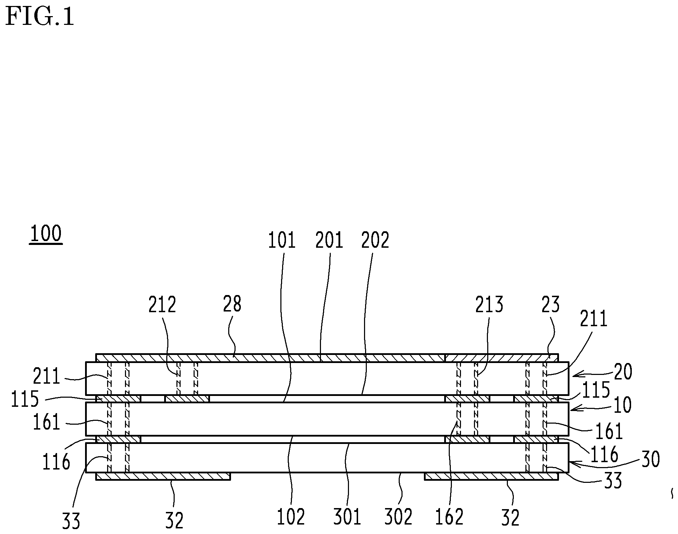

   FIG. 1 is a schematic configuration diagram schematically illustrating a configuration of a crystal resonator according to an embodiment.
[FIG. 2]

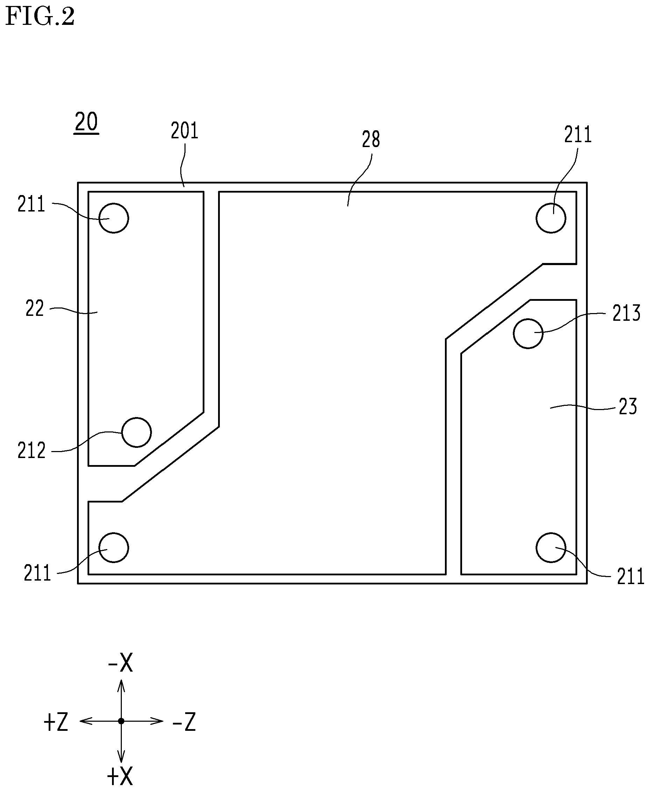

   FIG. 2 is a schematic plan view illustrating a first main surface of a first sealing member of the crystal resonator.
[FIG. 3]

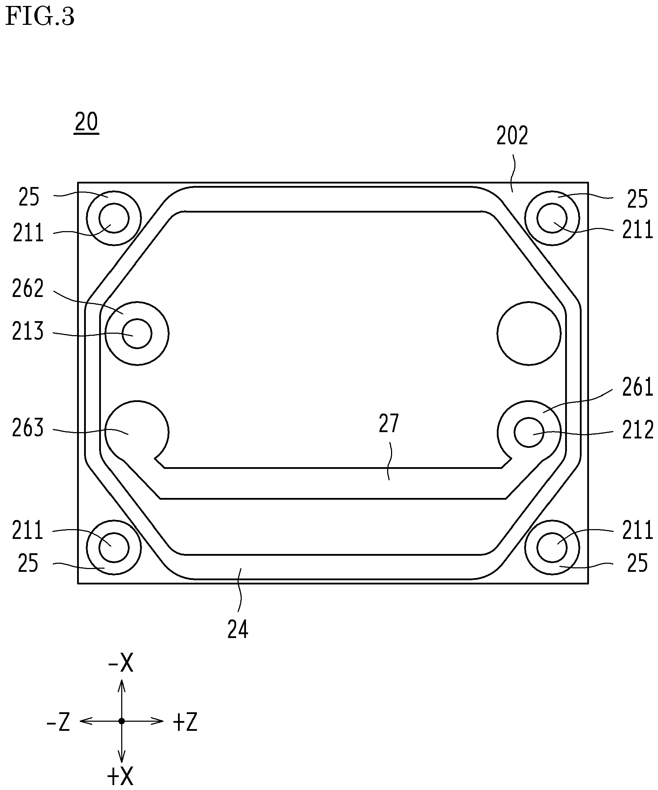

   FIG. 3 is a schematic plan view illustrating a second main surface of the first sealing member of the crystal resonator.
[FIG. 4]

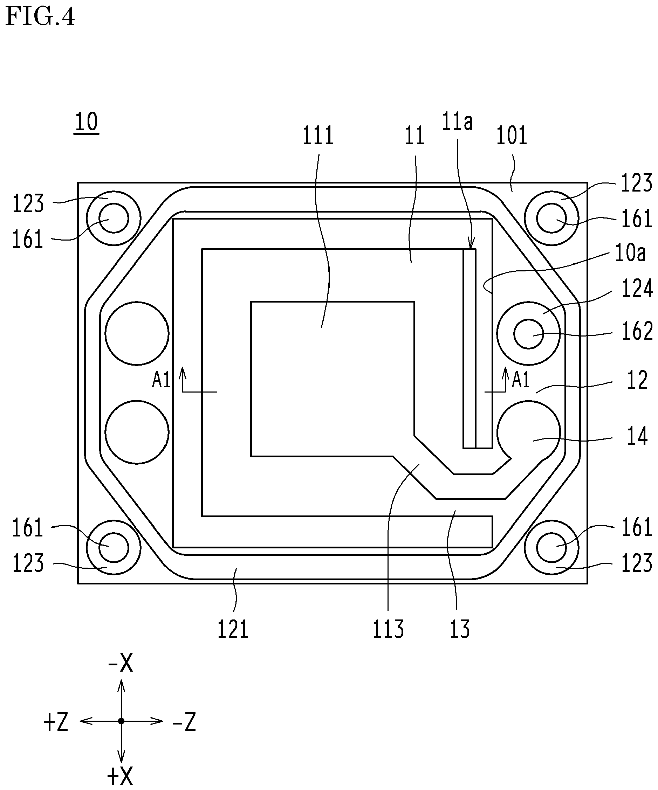

   FIG. 4 is a schematic plan view illustrating a first main surface of a crystal resonator plate of the crystal resonator.
[FIG. 5]

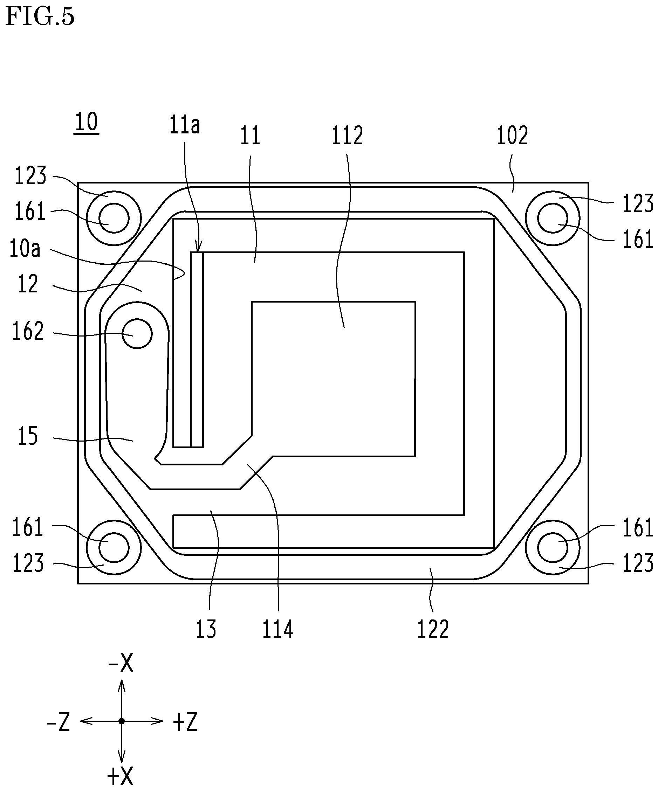

   FIG. 5 is a schematic plan view illustrating a second main surface of the crystal resonator plate of the crystal resonator.
[FIG. 6]

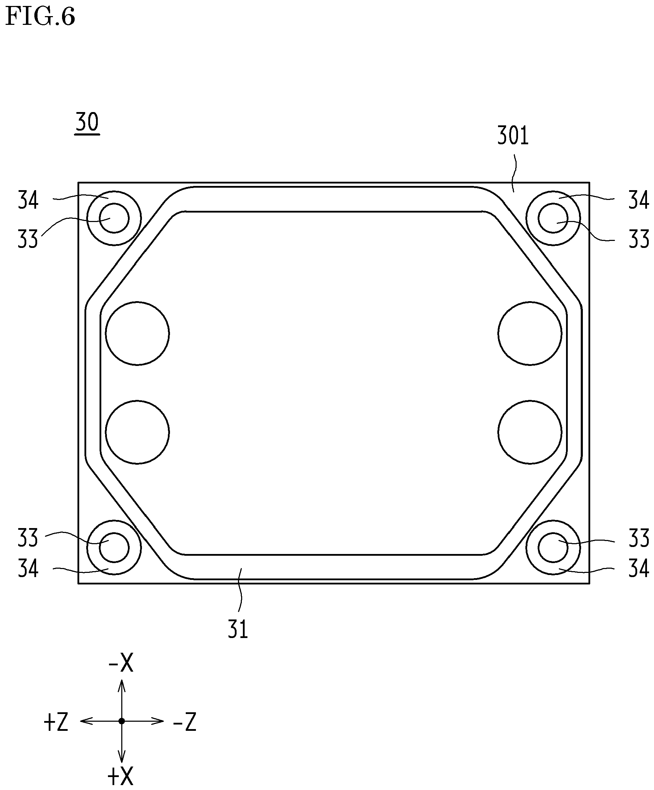

   FIG. 6 is a schematic plan view illustrating a first main surface of a second sealing member of the crystal resonator.
[FIG. 7]

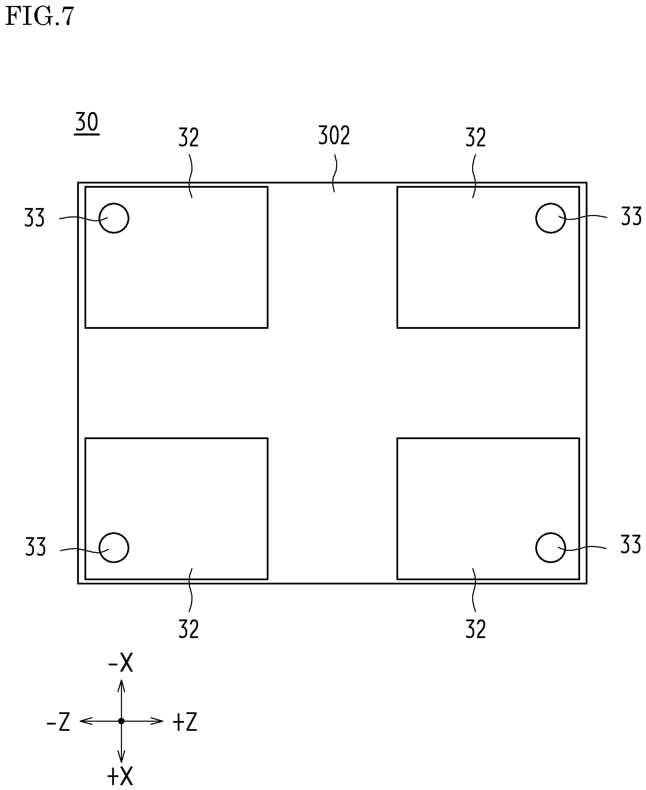

   FIG. 7 is a schematic plan view illustrating a second main surface of the second sealing member of the crystal resonator.
[FIG. 8]

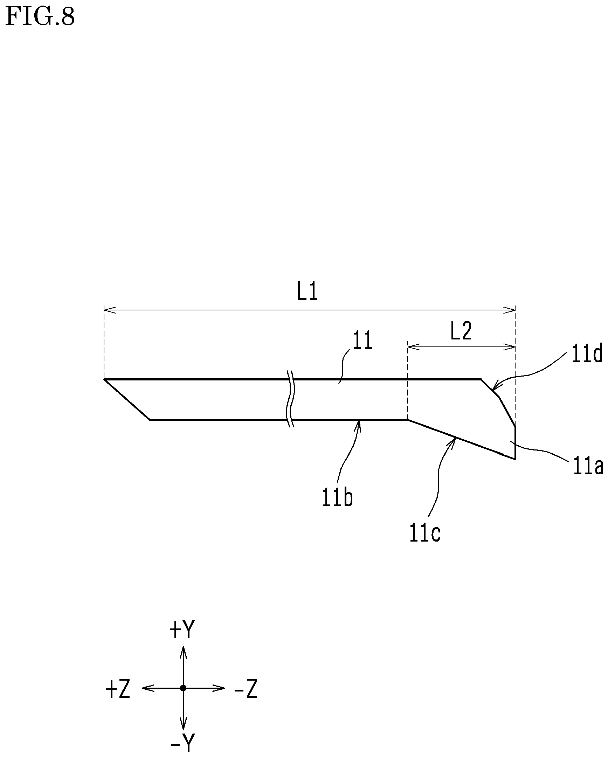

   FIG. 8 is a cross-sectional view taken from line A1-A1 of FIG. 4.
[FIGS. 9]

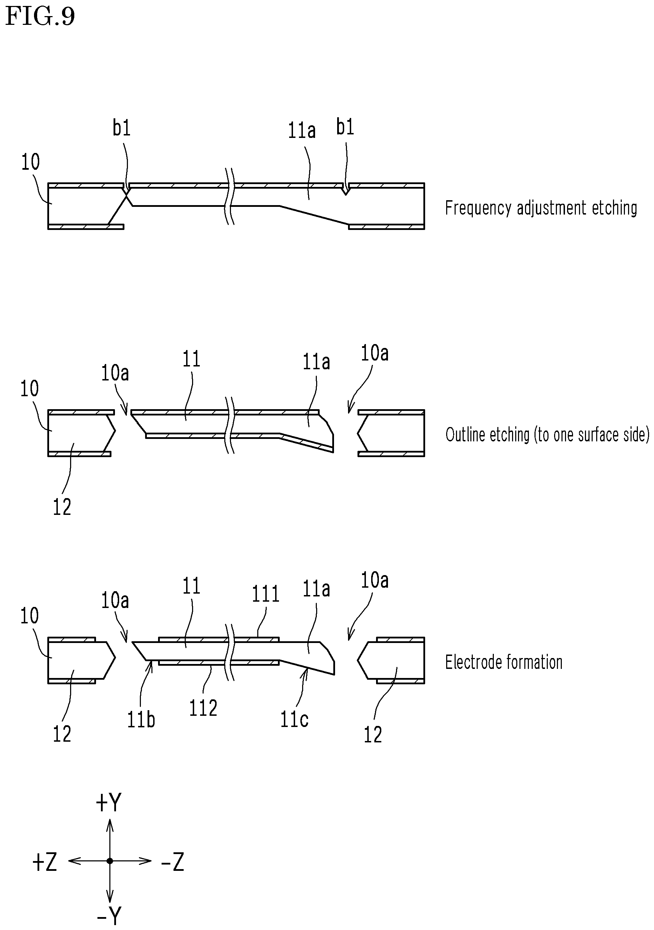

   FIGS. 9 are diagrams schematically showing a method for manufacturing the crystal resonator according to the embodiment.

### Mode for Carrying Out the Invention

Hereinafter, an embodiment of the present invention will be described in detail with reference to the drawings.

First, a basic configuration of a crystal resonator 100 according to this embodiment is described. As shown in FIG. 1, the crystal resonator 100 includes: a crystal resonator plate 10; a first sealing member 20; and a second sealing member 30. In this crystal oscillator 100, the crystal resonator plate 10 is bonded to the first sealing member 20, and furthermore the crystal resonator plate 10 is bonded to the second sealing member 30. Thus, a package having a sandwich structure is formed so as to have a substantially rectangular parallelepiped shape. That is, in the crystal resonator 100, the first sealing member 20 and the second sealing member 30 are bonded to respective main surfaces of the crystal resonator plate 10, thus an internal space (cavity) of the package is formed. In this internal space, a vibrating part 11 (see FIGS. 4 and 5) is hermetically sealed.

The crystal resonator 100 according to this embodiment has, for example, a package size of 1.0 × 0.8 mm, which is reduced in size and height. The crystal resonator 100 is electrically connected to an external circuit board (not shown) provided outside via solder.

Next, the respective components of the above-described crystal resonator 100 (i.e. the crystal resonator plate 10, the first sealing member 20 and the second sealing member 30) are described with reference to FIGS. 1 to 7. Here, each of the components is described as a single body without being bonded. FIGS. 2 to 7 merely show respective configuration examples of the crystal resonator plate 10, the first sealing member 20 and the second sealing member 30, and thus the present invention is not limited thereto.

The crystal resonator plate 10 is a piezoelectric substrate made of crystal as shown in FIGS. 4 and 5. Each main surface (i.e. a first main surface 101 and a second main surface 102) is formed as a smooth flat surface (mirror-finished). In this embodiment, an ST-cut crystal plate is used as the crystal resonator plate 10. In the crystal resonator plate 10 shown in FIGS. 4 and 5, each main surface 101 and 102 of the crystal resonator plate 10 is an XZ plane. On this XZ plane, the direction parallel to the lateral direction (short side direction) of the crystal resonator plate 10 is the X axis direction, and the direction parallel to the longitudinal direction (long side direction) of the crystal resonator plate 10 is the Z axis direction. The ST-cut method is a processing method for cutting out a crystal plate from a crystal having three crystal axes (i.e. an electrical axis (X axis), a mechanical axis (Y axis) and an optical axis (Z axis)). The method includes, for example: rotating a surface of a crystal orthogonally intersecting the Y axis about 33° around the X axis; and furthermore rotating the above rotated surface about 22° around the Z axis, so that the crystal plate is cut out of this surface. The X axis direction and the Z axis direction shown in FIGS. 4 and 5 are, as a matter of convenience, considered as cutting directions when the SC-cut crystal resonator plate is cut out (i.e. directions of the respective crystal axes after subjected to the above two-times rotation). The Y direction is also considered in the same way. The above-described cutting angle is an example, and the cutting angle may be another angle in the range of the general cutting angle of the SC-cut. For example, the rotating angle of the surface orthogonally intersecting the Y axis around the X axis may be about 33-35°, and the rotating angle of the above rotated surface around the Z axis may be about 22-24°.

A pair of excitation electrodes (i.e. a first excitation electrode 111 and a second excitation electrode 112) is formed, respectively, on the main surfaces 101 and 102 of the crystal resonator plate 10. The crystal resonator plate 10 includes: the vibrating part 11 formed so as to have a substantially rectangular shape; an external frame part 12 surrounding the outer periphery of the vibrating part 11; and a support part 13 that supports the vibrating part 11 by connecting the vibrating part 11 to the external frame part 12. That is, the crystal resonator plate 10 has a configuration in which the vibrating part 11, the external frame part 12 and the support part 13 are integrally formed. The support part 13 extends (protrudes) from only one corner part positioned in the +X direction and in the -Z direction of the vibrating part 11 to the external frame part 12 in the -Z direction. A penetrating part (slit) 10a is formed between the vibrating part 11 and the external frame part 12. In this embodiment, the crystal resonator plate 10 has only one support part 13 to connect the vibrating part 11 to the external frame part 12. The penetrating part 10a is continuously formed so as to surround the outer periphery of the vibrating part 11.

The first excitation electrode 111 is provided on the first main surface 101 side of the vibrating part 11 while the second excitation electrode 112 is provided on the second main surface 102 side of the vibrating part 11. The first excitation electrode 111 and the second excitation electrode 112 are respectively connected to lead-out wirings (a first lead-out wiring 113 and a second lead-out wiring 114) so that these excitation electrodes are connected to external electrode terminals. The first lead-out wiring 113 is drawn from the first excitation electrode 111 and connected to a connection bonding pattern 14 formed on the external frame part 12 via the support part 13. The second lead-out wiring 114 is drawn from the second excitation electrode 112 and connected to a connection bonding pattern 15 formed on the external frame part 12 via the support part 13.

Resonator-plate-side sealing parts to bond the crystal resonator plate 10 respectively to the first sealing member 20 and the second sealing member 30 are provided on the respective main surfaces (i.e. the first main surface 101 and the second main surface 102) of the crystal resonator plate 10. As the resonator-plate-side sealing part on the first main surface 101, a resonator-plate-side first bonding pattern 121 is formed. As the resonator-plate-side sealing part on the second main surface 102, a resonator-plate-side second bonding pattern 122 is formed. The resonator-plate-side first bonding pattern 121 and the resonator-plate-side second bonding pattern 122 are each formed on the external frame part 12 so as to have an annular shape in plan view.

Also, as shown in FIGS. 4 and 5, five through holes are formed in the crystal resonator plate 10 so as to penetrate between the first main surface 101 and the second main surface 102. More specifically, four first through holes 161 are respectively disposed in the four corners (corner parts) of the external frame part 12. A second through hole 162 is disposed in the external frame part 12, on one side in the Z axis direction with respect to the vibrating part 11 (in FIGS. 4 and 5, on the side of the -Z direction). Connection bonding patterns 123 are formed on the respective peripheries of the first through holes 161. Also, on the periphery of the second through hole 162, a connection bonding pattern 124 is formed on the first main surface 101 side while the connection bonding pattern 15 is formed on the second main surface 102 side.

In the first through holes 161 and the second through hole 162, through electrodes are respectively formed along a corresponding inner wall surface of the above through holes so as to establish conduction between the electrodes formed on the first main surface 101 and the second main surface 102. Respective center parts of the first through holes 161 and the second through hole 162 are hollow penetrating parts penetrating between the first main surface 101 and the second main surface 102. The outer peripheral edge of the resonator-plate-side first bonding pattern 121 is disposed so as to be adjacent to the outer peripheral edge of the first main surface 101 of the crystal resonator plate 10 (external frame part 12). The outer peripheral edge of the resonator-plate-side second bonding pattern 122 is disposed so as to be adjacent to the outer peripheral edge of the second main surface 102 of the crystal resonator plate 10 (external frame part 12). In this embodiment, the configuration is exemplarily described, in which five through holes are formed so as to penetrate between the first main surface 101 and the second main surface 102. However, the through holes are not necessarily required to be formed. In place of the through holes, a castellation may be used by cutting out a part of the side surface of the first sealing member 20, and attaching an electrode to an inner wall surface of the cut-out region. (In this case, this configuration is also applied to the second sealing member 30).

As shown in FIGS. 2 and 3, the first sealing member 20 is a substrate having a rectangular parallelepiped shape that is made of a single crystal plate. A second main surface 202 (a surface to be bonded to the crystal resonator plate 10) of the first sealing member 20 is formed as a smooth flat surface (mirror finished). By making the first sealing member 20, which does not have the vibrating part, of the SC-cut crystal plate as in the case of the crystal resonator plate 10, it is possible for the first sealing member 20 to have the same coefficient of thermal expansion as the crystal resonator plate 10. Thus, it is possible to prevent thermal deformation of the crystal resonator 100. Furthermore, the respective directions of the X axis, Y axis and Z axis of the first sealing member 20 are the same as those of the crystal resonator plate 10. The first sealing member 20 may also be made of a crystal plate with the cutting angle other than that of the SC-cut and the AT-cut, or also may be made of glass. (In this case, this configuration is also applied to the second sealing member 30).

As shown in FIG. 2, a first and second terminals 22 and 23 for wiring and a metal film 28 for sealing (for earth connection) are formed on a first main surface 201 (the outer main surface not facing the crystal resonator plate 10) of the first sealing member 20. The first and second terminals 22 and 23 for wiring are provided as the wirings for electrically connecting respectively the first and second excitation electrodes 111 and 112 of the crystal resonator plate 10 to external electrode terminals 32 of the second sealing member 30. The first and second terminals 22 and 23 are respectively provided on both end parts in the Z direction. Specifically, the first terminal 22 is provided on the end part in the + Z direction while the second terminal 23 is provided on the end part in the -Z direction. The first and second terminals 22 and 23 are both formed so as to extend in the X axis direction. The first and second terminals 22 and 23 are each formed so as to have a substantially rectangle shape. The metal film 28 is disposed between the first terminal 22 and the second terminal 23 at a predetermined distance from both the first terminal 22 and the second terminal 23. The metal film 28 is provided over almost the entire area of the first main surface 201 of the first sealing member 20, except for the area where the first terminal 22 and the second terminal 23 are provided. The metal film 28 is provided so as to cover from the end of the first main surface 201 of the first sealing member 20 in the +X direction to the end thereof in the -X direction.

As shown in FIGS. 2 and 3, six through holes are formed in the first sealing member 20 so as to penetrate between the first main surface 201 and the second main surface 202. More specifically, four third through holes 211 are respectively disposed in the four corners (corner parts) of the first sealing member 20. Fourth and fifth through holes 212 and 213 are disposed respectively in the +Z direction and in the -Z direction in FIGS. 2 and 3.

In the third through holes 211 and the fourth and fifth through holes 212 and 213, through electrodes are respectively formed along a corresponding inner wall surface of the above through holes so as to establish conduction between the electrodes formed on the first main surface 201 and the second main surface 202. Respective center parts of the third through holes 211 and the fourth and fifth through holes 212 and 213 are hollow penetrating parts penetrating between the first main surface 201 and the second main surface 202. The respective through electrodes of the two third through holes 211 and 211 that are diagonally positioned on the first main surface 201 of the first sealing member 20 (i.e. in FIGS. 2 and 3, the third through hole 211 positioned in the corner part in the +X direction and in the +Z direction and the third through hole 211 positioned in the corner part in the -X direction and in the -Z direction) are electrically connected via the metal film 28. Also, the through electrode of the third through hole 211 positioned in the corner part in the -X direction and in the +Z direction is electrically connected to the through electrode of the fourth through hole 212 via the first terminal 22. Furthermore, the through electrode of the third through hole 211 positioned in the corner part in the +X direction and in the -Z direction is electrically connected to the through electrode of the fifth through hole 213 via the second terminal 23.

On the second main surface 202 of the first sealing member 20, a sealing-member-side first bonding pattern 24 is formed as a sealing-member-side first sealing part so as to be bonded to the crystal resonator plate 10. The sealing-member-side first bonding pattern 24 is formed so as to have an annular shape in plan view. On the second main surface 202 of the first sealing member 20, connection bonding patterns 25 are respectively formed on the peripheries of the third through holes 211. A connection bonding pattern 261 is formed on the periphery of the fourth through hole 212, and a connection bonding pattern 262 is formed on the periphery of the fifth through hole 213. Furthermore, a connection bonding pattern 263 is formed on the side opposite to the connection bonding pattern 261 in the long axis direction of the first sealing member 20 (i.e. on the side of the -Z direction). The connection bonding pattern 261 and the connection bonding pattern 263 are connected to each other via a wiring pattern 27. The outer peripheral edge of the sealing-member-side first bonding pattern 24 is disposed so as to be adjacent to the outer peripheral edge of the second main surface 202 of the first sealing member 20.

As shown in FIGS. 6 and 7, the second sealing member 30 is a substrate having a rectangular parallelepiped shape that is made of a single crystal plate. A first main surface 301 (a surface to be bonded to the crystal resonator plate 10) of the second sealing member 30 is formed as a smooth flat surface (mirror finished). The second sealing member 30 is also preferably made of an SC-cut crystal plate as in the case of the crystal resonator plate 10, and the respective directions of the X axis, Y axis and Z axis of the second sealing member 30 are preferably the same as those of the crystal resonator plate 10.

On the first main surface 301 of the second sealing member 30, a sealing-member-side second bonding pattern 31 is formed as a sealing-member-side second sealing part so as to be bonded to the crystal resonator plate 10. The sealing-member-side second bonding pattern 31 is formed so as to have an annular shape in plan view. The outer peripheral edge of the sealing-member-side second bonding pattern 31 is disposed so as to be adjacent to the outer peripheral edge of the first main surface 301 of the second sealing member 30.

On a second main surface 302 (the outer main surface not facing the crystal resonator plate 10) of the second sealing member 30, four external electrode terminals 32 are formed, which are electrically connected to an external circuit board provided outside the crystal resonator 100. The external electrode terminals 32 are respectively located on four corners (corner parts) on the second main surface 302 of the second sealing member 30. The external electrode terminals 32 are respectively disposed along the internal space of the package of the crystal resonator 100 in plan view, and each have a substantially L-shape. The external electrode terminals 32 are also disposed so as to be superimposed on the external frame part 12 of the crystal resonator plate 10 in plan view.

As shown in FIGS. 6 and 7, four through holes are formed in the second sealing member 30 so as to penetrate between the first main surface 301 and the second main surface 302. More specifically, four sixth through holes 33 are respectively disposed in the four corners (corner parts) of the second sealing member 30. In the sixth through holes 33, through electrodes are respectively formed along a corresponding inner wall surface of the sixth through holes 33 so as to establish conduction between the electrodes formed on the first main surface 301 and the second main surface 302. In this way, the respective electrodes formed on the first main surface 301 are electrically conducted to the external electrode terminals 32 formed on the second main surface 302 via the through electrodes formed along the inner wall surfaces of the sixth through holes 33. Also, respective central parts of the sixth through holes 33 are hollow penetrating parts penetrating between the first main surface 301 and the second main surface 302. On the first main surface 301 of the second sealing member 30, connection bonding patterns 34 are respectively formed on the peripheries of the sixth through holes 33.

In the crystal oscillator 100 including the crystal resonator plate 10, the first sealing member 20 and the second sealing member 30 as described above, the crystal resonator plate 10 and the first sealing member 20 are subjected to the diffusion bonding in a state in which the resonator-plate-side first bonding pattern 121 and the sealing-member-side first bonding pattern 24 are superimposed on each other, and the crystal resonator plate 10 and the second sealing member 30 are subjected to the diffusion bonding in a state in which the resonator-plate-side second bonding pattern 122 and the sealing-member-side second bonding pattern 31 are superimposed on each other, thus, the package having the sandwich structure as shown in FIG. 1 is produced. Accordingly, the internal space of the package, i.e. the space to house the vibrating part 11 is hermetically sealed.

In this case, the respective connection bonding patterns as described above are also subjected to the diffusion bonding in a state in which they are each superimposed on the corresponding connection bonding pattern. Such bonding between the connection bonding patterns allows electrical conduction of the first excitation electrode 111, the second excitation electrode 112 and the external electrode terminals 32 of the crystal resonator 100. More specifically, the first excitation electrode 111 is connected to the external electrode terminal 32 via the first lead-out wiring 113, the wiring pattern 27, the fourth through hole 212, the first terminal 22, the third through hole 211, the first through hole 161 and the sixth through hole 33 in this order. The second excitation electrode 112 is connected to the external electrode terminal 32 via the second lead-out wiring 114, the second through hole 162, the fifth through hole 213, the second terminal 23, the third through hole 211, the first through hole 161 and the sixth through hole 33 in this order. Also, the metal film 28 is earth-connected (i.e. ground connection, using parts of the external electrode terminals 32) via the third through holes 211, the first through holes 161 and the sixth through holes 33 in this order.

In the crystal resonator 100, the bonding patterns are each preferably made of a plurality of layers laminated on the crystal plate, specifically, a Ti (titanium) layer and an Au (gold) layer deposited, by the vapor deposition or sputtering, in this order from the lowermost layer side. Also, the other wirings and electrodes formed on the crystal resonator 100 each preferably have the same configuration as the bonding patterns, which leads to patterning of the bonding patterns, wirings and the electrodes at the same time.

In the above-described crystal resonator 100, sealing parts (seal paths) 115 and 116 that hermetically seal the vibrating part 11 of the crystal resonator plate 10 are formed so as to have an annular shape in plan view. The seal path 115 is formed by the diffusion bonding (Au-Au bonding) of the resonator-plate-side first bonding pattern 121 and the sealing-member-side first bonding pattern 24 as described above. The outer edge and the inner edge of the seal path 115 both have a substantially octagon shape. In the same way, the seal path 116 is formed by the diffusion bonding (Au-Au bonding) of the resonator-plate-side second bonding pattern 122 and the sealing-member-side second bonding pattern 31 as described above. The outer edge and the inner edge of the seal path 116 both have a substantially octagon shape.

In the crystal resonator 100 having the seal paths 115 and 116 formed by the diffusion bonding as described above, the first sealing member 20 and the crystal resonator plate 10 have a gap of not more than 1.00 µm. The second sealing member 30 and the crystal resonator plate 10 have a gap of not more than 1.00 µm. That is, the thickness of the seal path 115 between the first sealing member 20 and the crystal resonator plate 10 is not more than 1.00 µm, and the thickness of the seal path 116 between the second sealing member 30 and the crystal resonator plate 10 is not more than 1.00 µm (specifically, the thickness in the Au-Au bonding in this embodiment is 0.15 to 1.00 µm). As a comparative example, the conventional metal paste sealing material containing Sn has a thickness of 5 to 20 µm.

In the crystal resonator 100 in this embodiment, the crystal resonator plate 10 has the penetrating part 10a between the vibrating part 11 and the external frame part 12 so as to penetrate the crystal resonator plate 10 in the thickness direction. A protruding (projecting) part 11a is formed at an end part of the vibrating part 11 at the side of the penetrating part 10a, in a manner of protruding in the thickness direction. The protruding part 11a has an inclined surface 11c that is inclined with respect to a vibrating surface 11b of the vibrating part 11. This configuration will be described with reference to FIGS. 4, 5 and 8.

The protruding part 11a is provided at the end part of the vibrating part 11 in the -Z axis direction so as to protrude in the thickness direction with respect to the vibrating surface 11b of the vibrating part 11. In the example shown in FIG. 8, the protruding part 11a protrudes upward from the vibrating surface 11b of the vibrating part 11 (for example, in the +Y direction). The protruding part 11a extends in the X axis direction so as to cover from the end part in the +X axis direction to the end part in the -X axis direction of the vibrating part 11.

The front surface of the protruding part 11a (the upper surface of FIG. 8) is the inclined surface 11c that is inclined at a predetermined angle with respect to the vibrating surface 11b (i.e. the XZ plane) of the vibrating part 11. The inclined surface 11c includes a curved inclined surface, a stepwise inclined surface, and an inclined surface having a small bent part. Also, on the opposite surface of the protruding part 11a (on the lower surface side in FIG. 8), a recess part that recesses in the thickness direction is provided, which is a second inclined surface 11d that is inclined in the same direction as the inclined surface 11c. The second inclined surface 11d is inclined at the angle different from the angle at which the inclined surface 11c is inclined, however, the second inclined surface 11d and the inclined surface 11c may be inclined at the same angle. In the example shown in FIG. 8, an inclined surface that is inclined with respect to the vibrating surface 11b of the vibrating part 11 is also provided at the end part of the vibrating part 11 in the +Z axis direction (i.e. on the left side in FIG. 8), however, on this side there is no protruding part that protrudes in the thickness direction.

The protruding part 11a protrudes from the vibrating surface 11b of the vibrating part 11 toward the penetrating part 10a by the length of L2. In other words, L2 is a width of the protruding part 11a in a first direction along the crystal axis of the crystal resonator plate 10 (in this case, in the Z axis direction). The width L2 of the protruding part 11a in the Z axis direction accounts for 10-30% of a width L1 of the vibrating part 11 in the Z axis direction. In the case where the crystal resonator plate 10 has a size of 1.0 × 0.8 mm, this width L2 is, for example, 60-70 µm while the width L1 of the vibrating part 11 in the Z axis direction is, for example, 550-570 µm. Also, in the case where the crystal resonator plate 10 has the size of 1.0 × 0.8 mm, the width of the penetrating part 10a in the Z axis direction is, for example, 50-60 µm.

Here, a method for manufacturing the crystal resonator 100 including the above inclined surface 11c is described with reference to FIGS. 9. FIGS. 9 are diagrams showing some steps of the manufacturing process of the crystal resonator 100. These steps are performed to the crystal resonator plate 10 in the state of wafer.

In the manufacturing process of the crystal resonator 100 as shown in FIGS. 9, the wafer of the crystal resonator plate 10 is subjected to a frequency adjustment etching step, an outline etching step, and an electrode formation step. The frequency adjustment etching step is a step of adjusting the oscillation frequency by adjusting the thickness of the crystal resonator plate 10 by subjecting the wafer of the crystal resonator plate 10 to wet etching. The frequency adjustment etching is performed to one surface side of the wafer of the crystal resonator plate 10. However, the frequency adjustment etching may be performed to both surface sides of the wafer of the crystal resonator plate 10.

By performing the frequency adjustment etching, a part that will become the above-described protruding part 11a appears in the wafer of the crystal resonator plate 10. In this embodiment, a groove b1 is formed, in the previous step of the frequency adjustment etching step, on a surface side opposite to the surface side that is etched in the frequency adjustment etching step. In this way, by forming the groove b1 before the frequency adjustment etching step, the penetrating part 10a whose width in the Z axis direction is extremely small is allowed to reliably penetrate the crystal resonator plate 10 in the frequency adjustment etching step.

The outline etching step is a step of forming the outline of the vibrating part 11 in the crystal resonator plate 10 by subjecting the wafer of the crystal resonator plate 10 to wet etching. The outline etching is performed to one surface side of the wafer of the crystal resonator plate 10 (i.e. to the surface side to which the frequency adjustment etching was performed). By performing the outline etching, the above-described penetrating part 10a is formed in the wafer of the crystal resonator plate 10, and thus the vibrating part 11 is divided from the external frame part 12 by the penetrating part 10a. At this time, the part for the protruding part 11a, which was formed by the frequency adjustment etching, remains at the end part of the vibrating part 11 at the side of the penetrating part 10a.

The electrode formation step is a step of forming the above-described first and second excitation electrodes 111 and 112 and the like on the vibrating part 11 by subjecting the wafer of the crystal resonator plate 10 in which the vibrating part 11, the external frame part 12 and the penetrating part 10a have been formed to sputtering or photolithography.

In this embodiment, since the oscillation of the crystal resonator 100 in B mode is reduced by the inclined surface 11c of the protruding part 11a, it is possible to certainly make the crystal resonator 100 oscillate in C mode as the main vibration (fundamental wave), and thus, it is possible to provide a highly reliable crystal resonator 100. Here, since the oscillation in C mode as the main vibration of the SC-cut crystal resonator 100 is mainly performed by the flat part (i.e. the vibrating surface 11b) of the vibrating part 11, the protruding part 11a hardly affects the vibration in C mode. On the other hand, the protruding part 11a remarkably affects the oscillation in B mode as the sub vibration. The smaller the chip size of the crystal resonator 100 becomes, the larger the influence of the protruding part 11a becomes. Due to the inclined surface 11c of the protruding part 11a, the CI of the oscillation in B mode increases (degrades), which prevents the oscillation in B mode. As a result, it is possible to certainly make the crystal resonator 100 oscillate in C mode that is not likely to be affected by the protruding part 11a.

Also, on the part opposite to the inclined surface 11c of the protruding part 11a, the second inclined surface 11d is formed, which is inclined in the direction in which the inclined surface 11c protrudes. Thus, it is possible to effectively reduce the oscillation of the crystal resonator 100 in B mode by both the inclined surface 11c and the second inclined surface 11d of the protruding part 11a. As a result, it is possible to certainly make the crystal resonator 100 oscillate in C mode as the main vibration, and thus, it is possible to provide a highly reliable crystal resonator 100.

In this embodiment, the width L2 of the protruding part 11a in the Z axis direction of the crystal resonator plate 10 accounts for 10-30% of the width L1 of the vibrating part 11 in the Z axis direction. Thus, the oscillation of the crystal resonator 100 in B mode is reduced by the inclined surface 11c of the protruding part 11a having a certain width L2. As a result, it is possible to certainly make the crystal resonator 100 oscillate in C mode as the main vibration, and thus, it is possible to provide a highly reliable crystal resonator 100. If the width L2 of the protruding part 11a in the Z axis direction of the crystal resonator plate 10 accounts for less than 10% of the width L1 of the vibrating part 11 in the Z axis direction, the protruding part 11a can exert only a small influence with respect to the chip size of the crystal resonator 100, which leads to an insufficient effect to reduce the oscillation in B mode. On the other hand, if the width L2 of the protruding part 11a in the Z axis direction of the crystal resonator plate 10 accounts for more than 30% of the width L1 of the vibrating part 11 in the Z axis direction, the flat part (i.e. the vibrating surface 11b) of the vibrating part 11 is reduced by the width L2, which results in an increased negative impact on the oscillation in C mode as the main vibration.

Also, the protruding part 11a is provided at the end part of the vibrating part 11 in the -Z axis direction so as to extend in the X axis direction. Thus, the oscillation of the crystal resonator 100 in B mode is reduced by the inclined surface 11c of the protruding part 11a having a certain width L2 in the Z axis direction. As a result, it is possible to certainly make the crystal resonator 100 oscillate in C mode as the main vibration, and thus, it is possible to provide a highly reliable crystal resonator 100.

Furthermore, in the above-described method for manufacturing the crystal resonator 100 having the protruding part 11a, by subjecting one surface side of the crystal resonator plate 10 to the frequency adjustment etching, the inclined surface 11c that is inclined with respect to the vibrating surface 11b of the vibrating part 11 appears due to crystal anisotropy. The smaller the size of the crystal resonator 100 becomes, the smaller the width of the penetrating part 10a becomes, which leads to a smaller amount of etching by the outline etching to form the penetrating part 10a. Thus, after the outline etching step is performed, the inclined surface 11c formed by the frequency adjustment etching remains, as the protruding part 11a, at the end part of the vibrating part 11. In the embodiment of the present invention, the height (maximum thickness) of the protruding part 11a in the Y axis direction is smaller than the height (thickness) of the external frame part 12. Thus, the oscillation of the crystal resonator 100 in B mode can be reduced by the protruding part 11a. As a result, it is possible to certainly make the crystal resonator 100 oscillate in C mode as the main vibration, and thus, it is possible to provide a highly reliable crystal resonator 100.

The foregoing embodiment is to be considered in all respects as illustrative and not limiting. The technical scope of the invention is indicated by the appended claims rather than by the foregoing description, and all modifications and changes that come within the meaning and range of equivalency of the claims are intended to be embraced therein.

In the above-described embodiment, the crystal resonator plate 10 has only one support part 13 to connect the vibrating part 11 to the external frame part 12, and the penetrating part 10a is continuously formed so as to surround the outer periphery of the vibrating part 11. However, the configuration of the crystal resonator plate 10 may be variously changed provided that the penetrating part 10a is disposed between the vibrating part 11 and the external frame part 12. For example, the crystal resonator plate 10 may have two or more support parts 13 to connect the vibrating part 11 to the external frame part 12.

The above-described shape of the protruding part 11a is an example. The shape of the protruding part 11a may be variously changed provided that the inclined surface 11c that is inclined with respect to the vibrating surface 11b of the vibrating part 11 is formed.

In the above-described embodiment, the number of the external electrode terminals 32 on the second main surface 302 of the second sealing member 30 is four. However, the present invention is not limited thereto. The number of the external electrode terminals 32 may be, for example, two, six, or eight. Also in the above-described embodiment, the present invention is applied to the crystal resonator 100. However, the present invention may also be applied to, for example, a crystal oscillator or the like.

Also in the above-described embodiment, the conduction between the electrodes in the crystal resonator 100 is mainly performed via the through holes. However, the conduction between the electrodes may also be performed via the castellations formed in the wall surfaces of the inner and outer walls or side walls of the package of the crystal resonator 100.

In the above-described embodiment, the first sealing member 20 and the second sealing member 30 are each made of a crystal plate. However, the present invention is not limited thereto. The first sealing member 20 and the second sealing member 30 may be made of, for example, glass or resin.

This application claims priority based on Patent Application No. 2021-043931 filed in Japan on March 17, 2021. The entire contents thereof are hereby incorporated in this application by reference.

### Description of the Reference Numerals

- 10: Crystal resonator plate (SC-cut crystal resonator plate)
- 10a: Penetrating part
- 11: Vibrating part
- 11a: Protruding part
- 11b: Vibrating surface
- 11c: Inclined surface
- 12: External frame part
- 100: Crystal resonator (SC-cut crystal resonator)

## Claims

1. A crystal resonator comprising an SC-cut crystal resonator plate, wherein
the SC-cut crystal resonator plate includes: a vibrating part; an external frame part provided at a side of an outer periphery of the vibrating part; and a penetrating part provided between the vibrating part and the external frame part so as to penetrate the SC-cut crystal resonator plate in a thickness direction of the SC-cut crystal resonator plate, and
an inclined surface is provided at an end part of the vibrating part at a side of the penetrating part so as to protrude in the thickness direction and to be inclined with respect to a vibrating surface of the vibrating part.

2. The crystal resonator according to claim 1, wherein
a second inclined surface is formed on a part opposite to the inclined surface so as to be inclined in the direction in which the inclined surface protrudes.

3. The crystal resonator according to claim 1 or 2, wherein
a width of the inclined surface in a first direction along a crystal axis of the SC-cut crystal resonator plate accounts for 10% or more of a width of the vibrating part in the first direction.

4. The crystal resonator according to any one of claims 1 to 3, wherein
the inclined surface is provided at the end part of the vibrating part in a Z axis direction of the SC-cut crystal resonator plate so as to extend in an X axis direction of the SC-cut crystal resonator plate.

5. A method for manufacturing a crystal resonator including an SC-cut crystal resonator plate, the method comprising the steps of:
performing a frequency adjustment etching to one surface side of the SC-cut crystal resonator plate; and
performing an outline etching, after the frequency adjustment etching, to form a penetrating part at an end part of a vibrating part, so that an inclined surface is formed at the end part of the vibrating part at a side of the penetrating part so as to protrude in a thickness direction and to be inclined with respect to a vibrating surface of the vibrating part.

6. The method for manufacturing a crystal resonator according to claim 5, wherein
a width of the inclined surface in a first direction along a crystal axis of the SC-cut crystal resonator plate accounts for 10% or more of a width of the vibrating part in the first direction.

7. The method for manufacturing a crystal resonator according to claim 5 or 6, wherein
the inclined surface is provided at the end part of the vibrating part in a Z axis direction of the SC-cut crystal resonator plate so as to extend in an X axis direction of the SC-cut crystal resonator plate.
